# EUROPEAN PATENT APPLICATION

(11) **EP 4 845 343 A1**
(43) Date of publication of application: **25.11.2026**
(21) Application number: 25853027.8
(22) Date of filing: 25.07.2025
(51) Int. Cl.: H10F 10/14

(54) **SOLAR CELL, CELL MODULE AND PHOTOVOLTAIC SYSTEM**

(30) Priority: 11.04.2025 CN 202510456070
(71) Applicant: Tianjin Aiko Solar Energy Technology Co., Ltd., Tianjin 300400 (CN)
(72) Inventor: QIU, Kaifu, Yiwu City, Jinhua, Zhejiang 322009 (CN); WANG, Yongqian, Yiwu City, Jinhua, Zhejiang 322009 (CN); YANG, Xinqiang, Yiwu City, Jinhua, Zhejiang 322009 (CN); CHEN, Gang, Yiwu City, Jinhua, Zhejiang 322009 (CN)
(74) Representative: EP&C
(86) International application number: PCT/CN2025/110640
(87) International publication number: WO 2026/213986

(57) **Abstract**

The present disclosure is applicable to the technical field of photovoltaics. Provided are a solar cell, a cell assembly, and a photovoltaic system. A first region and a second region are alternately distributed on a backlight surface of the solar cell and are connected through a connection region. A first polarity functional layer group is disposed on the first region, and at a specific position in the connection region, some layers extend above the connection region. A second polarity functional layer group is located in the second region. A third polarity functional layer group is located in the connection region, and some layers form a wrapping portion covering an extending portion and extending to the first polarity functional layer group. An edge of the wrapping portion close to the connection region is a first boundary line, an edge away from the connection region is a second boundary line, and the degree of undulation of the first boundary line is greater than that of the second boundary line. The first boundary line has a high degree of undulation, thereby increasing the contact area between the second polarity functional layer group and the first polarity functional layer group and improving the hot spot effect. The second boundary line has a low degree of undulation, thereby reducing the contact area with the first polarity functional layer group, decreasing the parasitic absorption, and improving the conversion efficiency.

## Description

This application claims priority to and benefits of Chinese Patent Application No. 202510456070.6, filed to the China National Intellectual Property Administration on April 11, 2025, the disclosure of which is hereby incorporated by reference in its entirety.

### Technical Field

The present disclosure belongs to the technical field of photovoltaics, and in particular, to a solar cell, a cell assembly, and a photovoltaic system.

### Background

As one of the most abundant renewable energy sources, solar energy has great development potential and application prospects. A solar cell is a core device that directly converts solar energy into electric energy, and is a key technology to achieve efficient utilization of the solar energy. Photoelectric conversion efficiency refers to a proportion of incident light energy converted by the solar cell into the electric energy, and is a core indicator to measure the performance of the solar cell. Improving the photoelectric conversion efficiency may increase the electric energy output per unit area and reduce the power generation cost.

At present, the photoelectric conversion efficiency of commercial silicon-based solar batteries is about 20% to 25%. Improving the photoelectric conversion efficiency of the solar batteries is an important part of solar cell research and development. Improving the photoelectric conversion efficiency may increase the electric energy output per unit area and reduce the power generation cost, thereby shortening the investment payback period, enhancing market competitiveness, and promoting the rapid development of the photovoltaic industry. Therefore, improving the photoelectric conversion efficiency of the solar batteries is not only of important economic, environmental and technical significance, but also crucial for promoting the sustainable development of the photovoltaic industry.

### Summary

The present disclosure provides a solar cell, a cell assembly, and a photovoltaic system, aiming at improving the photoelectric conversion efficiency of the solar cell and solving the problem of low photoelectric conversion efficiency of the solar cell.

The present disclosure is implemented in this way. A solar cell includes a silicon substrate, a first polarity functional layer group, a second polarity functional layer group, and a third polarity functional layer group.

The silicon substrate has a backlight surface and a light-receiving surface, which are oppositely disposed, the backlight surface includes a first region and a second region, a distance from the first region to the light-receiving surface is greater than a distance from the second region to the light-receiving surface, the first region and the second region are alternately disposed, the second region extends toward the first region to form a connection region, and the connection region partially overlaps with the first region.

The first polarity functional layer group is disposed on the first region in a stacked manner, and at a first preset position of the connection region, along an arrangement direction of the first region and the second region, at least some functional layers in the first polarity functional layer group have an extending portion extending above the connection region.

The second polarity functional layer group is disposed on the second region in a stacked manner.

The third polarity functional layer group is disposed on the connection region in a stacked manner, the polarity of the third polarity functional layer group is the same as that of the second polarity functional layer group, and the polarity of the third polarity functional layer group is different from that of the first polarity functional layer group.

At the first preset position, the first polarity functional layer group is in composite contact with the third polarity functional layer group, at least some functional layers in the third polarity functional layer group have a wrapping portion, and the wrapping portion covers the extending portion in a stacked manner and extends to cover the first polarity functional layer group.

An edge of the wrapping portion closest to the connection region is a first boundary line, an edge of the wrapping portion farthest away from the connection region is a second boundary line, and the degree of undulation of the first boundary line is greater than that of the second boundary line.

Optionally, the adjacent first region and the second region are separated by a groove region, a portion of the second region is connected to the first region through the connection region, an edge of the first polarity functional layer group closest to the groove region is a third boundary line, and the degree of undulation of the third boundary line is greater than that of the first boundary line.

Optionally, the first polarity functional layer group includes a first dielectric layer and a first polarity doped layer, the second polarity functional layer group includes a second dielectric layer and a second polarity doped layer, and the third polarity functional layer group includes a third dielectric layer, a fourth dielectric layer, and a third polarity doped layer.

The first dielectric layer is disposed on the first region in a stacked manner, the first polarity doped layer is disposed on the first dielectric layer in a stacked manner, at the first preset position, along an arrangement direction of the connection region and the first region, the first polarity doped layer has a first extending portion extending above the connection region, and the first extending portion has a first surface facing the connection region and a second surface facing away from the connection region.

The second dielectric layer is disposed on the second region in a stacked manner, and the second polarity doped layer is disposed on the second dielectric layer in a stacked manner.

The third dielectric layer is disposed on the connection region in a stacked manner, the fourth dielectric layer is disposed on at least a portion of the first surface, the fourth dielectric layer has a tunneling function, the third polarity doped layer is disposed on the third dielectric layer and the fourth dielectric layer in a stacked manner, the third polarity doped layer on the third dielectric layer is connected to the third polarity doped layer on the fourth dielectric layer, the third polarity doped layer has a first wrapping portion at the first preset position, and the first wrapping portion wraps around an end of the first extending portion and a second surface of the first extending portion and extends to the first region.

Optionally, an insulating layer is disposed between the first wrapping portion and the second surface.

Optionally, the insulating layer has a second extending portion protruding from the first extending portion along the arrangement direction of the connection region and the first region.

Optionally, the first surface and the second surface intersect at the end of the first extending portion to form a tip portion, and the first wrapping portion wraps around the tip portion.

Optionally, an end of the tip portion has a hole.

Optionally, at a second preset position of the groove region, along the arrangement direction of the first region and the second region, the first polarity doped layer has a third extending portion extending above the groove region.

The present disclosure further provides a cell assembly, including the above solar cell.

The present disclosure further provides a photovoltaic system, including the above cell assembly.

The beneficial effects achieved by the present disclosure are that the first region and the second region are alternately distributed on the backlight surface of the solar cell, separated by the groove region, and connected through the connection region. The first polarity functional layer group is disposed on the first region, and at a specific position in the connection region, some layers extend above the connection region. The second polarity functional layer group is located in the second region, the third polarity functional layer group is located in the connection region, and some layers form the wrapping portion covering the extending portion and extending to the first polarity functional layer group. The edge of the wrapping portion close to the connection region is the first boundary line, the edge away from the connection region is the second boundary line, and the degree of undulation of the first boundary line is greater than that of the second boundary line. The first boundary line has a high degree of undulation, thereby increasing the contact area between the third polarity functional layer group and the first polarity functional layer group and improving the anti-hot spot effect, so that photo-generated carriers are more efficiently collected into the third polarity functional layer group and transported to an electrode, thereby improving the short-circuit current and photoelectric conversion efficiency. The second boundary line has a low degree of undulation, thereby reducing the contact area with the first polarity functional layer group, decreasing the parasitic absorption, and improving the conversion efficiency. At the same time, the recombination of the carriers at the boundary may be reduced and the collection efficiency may be improved.

### Brief Description of the Drawings

Fig. 1 is a first schematic structural diagram of a solar cell provided by the present disclosure.
Fig. 2 is a second schematic structural diagram of a solar cell provided by the present disclosure.
Fig. 3 is a third schematic structural diagram of a solar cell provided by the present disclosure.
Fig. 4 is a fourth schematic structural diagram of a solar cell provided by the present disclosure.
Fig. 5 is a schematic cross-sectional view of a solar cell provided by the present disclosure.
Fig. 6 is an enlarged view at a position A.
Fig. 7 is another schematic cross-sectional view of a solar cell provided by the present disclosure.
Fig. 8 is a schematic structural diagram of a silicon substrate provided by the present disclosure.
Fig. 9 is an enlarged microscopic top view of a solar cell provided by the present disclosure.

### Illustration of reference signs:

100. Solar cell; 110. Silicon substrate; 101. First region; 102. Second region; 103. Groove region; 104. Connection region; 111. First notch; 1111. First sidewall; 1112. Second sidewall; 112. Second notch; 1121. Third sidewall; 1122. Fourth sidewall; 113. First bottom edge; 114. Second bottom edge; 115. Third bottom edge; 120. First polarity functional layer group; 121. First dielectric layer; 122. First polarity doped layer; 1221. Third extending portion; 1222. First extending portion; 1222.1. First surface; 1222.2. Second surface; 1222.3. Tip portion; 130. Second polarity functional layer group; 131. Second dielectric layer; 132. Second polarity doped layer; 140. Insulating layer; 141. Second extending portion; 150. Passivation layer; 160. Third polarity functional layer group; 161. Third dielectric layer; 162. Fourth dielectric layer; 163. Third polarity doped layer; 1631. Wrapping portion;
1001. First boundary line; 1002. Second boundary line; 1003. Third boundary line; 1004. First edge; 1005. Second edge; and 1006. Third edge.

### Detailed Description of the Embodiments

In order to make the objectives, technical solutions and advantages of the present disclosure clearer, the present disclosure is further described below in detail in conjunction with the accompanying drawings and embodiments. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it should be understood that the orientations or positional relationships indicated by the terms "length", "width", "upper", "down", "left", "right", "horizontal", "top", "bottom", and the like are based on the orientations or positional relationships shown in the accompanying drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In addition, the terms "first" and "second" are used for descriptive purposes only, and cannot be understood as indicating or implying relative importance or implicitly specifying the number of technical features indicated. Therefore, the features defined with "first" and "second" may explicitly or implicitly include one or more features. In the description of the present disclosure, "a plurality of" means two or more, unless explicitly and specifically defined otherwise.

In the description of the present disclosure, it is to be noted that, unless otherwise clearly specified and limited, the terms "mounted", "connected" and "connect" should be interpreted broadly. For example, the term "connect" may be fixed connection, detachable connection or integral construction. As an alternative, the term "connect" may be mechanical connection, or electrical connection, or mutual communication. As an alternative, the term "connect" may be direct connection, or indirect connection through a medium, or communication in two elements or the interaction between two elements. For those of ordinary skill in the art, specific meanings of the above terms in the present disclosure may be understood based on specific situations.

In the present disclosure, unless otherwise explicitly specified and defined, a first feature being "over" or "below" a second feature may include that the first feature and the second feature are in direct contact, or the first feature and the second feature are not in direct contact but are in contact through another feature. Moreover, the first feature being "over", "above" and "on" the second feature includes the first feature being directly above and obliquely above the second feature, or simply indicates that the horizontal height of the first feature is larger than that of the second feature. The first feature being "beneath", "below" and "under" the second feature includes the first feature being directly below and obliquely below the second feature, or simply indicates that the horizontal height of the first feature is smaller than that of the second feature.

The following disclosure provides various different embodiments or examples for implementing different structures of the present disclosure. In order to simplify the disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art may be aware of the application of other processes and/or usage of other materials.

A first region and a second region are alternately distributed on a backlight surface of a solar cell of the present disclosure, separated by a groove region, and connected through a connection region. A first polarity functional layer group is disposed on the first region, and at a specific position in the connection region, some layers extend above the connection region. A second polarity functional layer group is located in the second region, a third polarity functional layer group is located in the connection region, and some layers form a wrapping portion covering an extending portion and extending to the first polarity functional layer group. An edge of the wrapping portion close to the connection region is a first boundary line, an edge away from the connection region is a second boundary line, and the degree of undulation of the first boundary line is greater than that of the second boundary line. The degree of undulation of the first boundary line is high, thereby increasing the contact area between the third polarity functional layer group and the first polarity functional layer group and improving the hot spot effect, so that photo-generated carriers are more efficiently collected into the third polarity functional layer group and transported to an electrode, thereby improving the short-circuit current and photoelectric conversion efficiency. The degree of undulation of the second boundary line is low, thereby reducing the contact area with the first polarity functional layer group, decreasing the parasitic absorption, and improving the conversion efficiency. At the same time, the recombination of the carriers at the boundary may be reduced and the collection efficiency may be improved.

### Embodiment

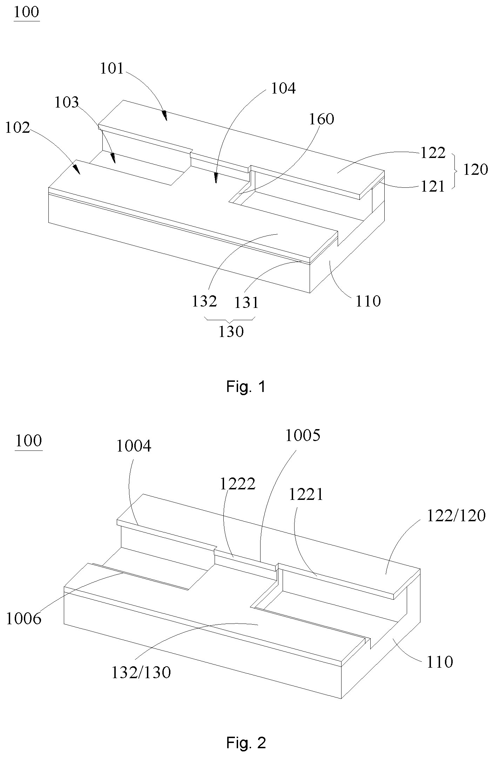

As shown in Fig. 1 to Fig. 9, the present embodiment provides a solar cell 100, including: a silicon substrate 110, a first polarity functional layer group 120, a second polarity functional layer group 130, and a third polarity functional layer group 160.

The silicon substrate 110 has a backlight surface and a light-receiving surface, which are oppositely disposed, the backlight surface includes a first region 101 and a second region 102, a distance from the first region 101 to the light-receiving surface is greater than a distance from the second region 102 to the light-receiving surface, the first region 101 and the second region 102 are alternately disposed, the second region 102 extends toward the first region 101 to form a connection region 104, and the connection region 104 partially overlaps with the first region 101.

The first polarity functional layer group 120 is disposed on the first region 101 in a stacked manner, and at a first preset position, along an arrangement direction of the first region 101 and the second region 102, at least some functional layers in the first polarity functional layer group 120 have an extending portion extending above the connection region 104.

The second polarity functional layer group 130 is disposed on the second region 102 in a stacked manner.

The third polarity functional layer group 160 is disposed on the connection region 104 in a stacked manner, the polarity of the third polarity functional layer group 160 is the same as that of the second polarity functional layer group 130, and the polarity of the third polarity functional layer group 160 is different from that of the first polarity functional layer group 120.

At the first preset position, the first polarity functional layer group 120 is in composite contact with the third polarity functional layer group 160, at least some functional layers in the third polarity functional layer group 160 have a wrapping portion, and the wrapping portion covers the extending portion in a stacked manner and extends to cover the first polarity functional layer group 120.

An edge of the wrapping portion closest to the connection region 104 is a first boundary line 1001, an edge of the wrapping portion farthest away from the connection region 104 is a second boundary line 1002, and the degree of undulation of the first boundary line 1001 is greater than that of the second boundary line 1002.

The silicon substrate 110 has two main surfaces, namely the light-receiving surface and the backlight surface. The light-receiving surface directly faces the sunlight, while the backlight surface is the other side. The two surfaces are oppositely disposed.

Two different regions, namely the first region 101 and the second region 102, are disposed on the backlight surface of the silicon substrate 110, and the two regions are alternately arranged. Specifically, a plurality of first regions 101 and a plurality of second regions 102 are alternately arranged along a first direction, both the first regions 101 and the second regions 102 extend along a second direction, and the second direction intersects with the first direction. The first regions 101 and the second regions 102 may be alternately arranged in a lateral direction of the silicon substrate 110 and both extend along a longitudinal direction, that is, the first direction may be a lateral direction of the solar cell, the second direction may be a longitudinal direction of the solar cell, and the two directions are perpendicular to each other. Of course, in other embodiments, the first direction and the second direction may be other directions, for example, the two directions may be diagonal directions of the silicon substrate 110, respectively, which is not specifically limited herein. The first region 101 and the second region 102 do not overlap each other, and the first region 101 and the second region 102 are adjacently disposed.

The distance from the first region 101 to the light-receiving surface is greater than the distance from the second region 102 to the light-receiving surface, that is, assuming that the light-receiving surface is placed downward, the position of the first region 101 on the silicon substrate 110 is higher than the position of the second region 102, and the first region 101 and the second region 102 have a height difference.

The first polarity functional layer group 120 is disposed on the first region 101, and the first polarity functional layer group 120 usually includes a plurality of layers with different functions, such as a doped layer, a conductive layer, and a tunneling layer. These functional layers act together, so that the first polarity functional layer group 120 exhibits polarity. The second polarity functional layer group 130 is disposed on the second region 102, and the second polarity functional layer group 130 usually includes a plurality of layers with different functions, such as a doped layer, a conductive layer, and a tunneling layer. These functional layers act together, so that the second polarity functional layer group 130 exhibits polarity. The polarity of the first polarity functional layer group 120 is different from that of the second polarity functional layer group 130. Specifically, the first polarity functional layer group 120 may be a P-type functional layer group, and the second polarity functional layer group 130 may be an N-type functional layer group, or the first polarity functional layer group 120 may be an N-type functional layer group, and the second polarity functional layer group 130 may be a P-type functional layer group. The first polarity functional layer group 120 and the second polarity functional layer group 130 form regions having different electrical characteristics, and support the formation of a PN junction and the separation of the carriers.

The second region 102 extends toward the first region 101 to form the connection region 104 partially overlapping with the first region 101, that is, the connection region 104 is disposed between the first region 101 and the second region 102, and covers a portion of the first region 101 to play a role of connecting the two. It may be understood that when the first region 101 and the second region 102 are adjacently disposed, a sidewall connecting the first region 101 and the second region 102 is disposed therebetween, and the connection region 104 is the sidewall between the first region 101 and the second region 102 and a portion of the first region 101 corresponding to the sidewall. When other regions are disposed between the first region 101 and the second region 102, the connection region 104 includes a first portion and a second portion. The first portion is disposed in the other regions between the first region 101 and the second region 102, and the second portion is a sidewall between the first portion and the second region 102 and a portion of the first region 101 corresponding to the sidewall.

At the first preset position of the connection region 104, along the arrangement direction of the first region 101 and the second region 102, at least some functional layers in the first polarity functional layer group 120 have the extending portion extending above the connection region 104. One or more functional layers in the first polarity functional layer group 120 have the extending portion, and the extending portion is placed above the connection region 104. It may be understood that the first polarity functional layer group 120 is disposed on a surface of the first region 101, and the extending portion is placed above the connection region 104, that is, the surface of the first region 101 is higher than a surface of the connection region 104.

The third polarity functional layer group 160 is disposed on the connection region 104 in a stacked manner, and the third polarity functional layer group 160 usually includes a plurality of layers with different functions, such as a doped layer, a conductive layer, and a tunneling layer. These functional layers act together, so that the third polarity functional layer group 160 exhibits polarity. The polarity of the third polarity functional layer group 160 is the same as that of the second polarity functional layer group 130, and is different from that of the first polarity functional layer group 120. The third polarity functional layer group 160 may be connected to the second polarity functional layer group 130, that is, the third polarity functional layer group 160 and the second polarity functional layer group 130 may be of an integrated structure, and each functional layer in the third polarity functional layer group 160 is integrally connected to each functional layer in the second polarity functional layer group 130 (for example, the doped layer in the third polarity functional layer group 160 is integrally connected to the doped layer in the second polarity functional layer group 130, and the tunneling layer in the third polarity functional layer group 160 is integrally connected to the tunneling layer in the second polarity functional layer group 130). An insulating medium may also be disposed between the third polarity functional layer group 160 and the second polarity functional layer group 130, and the third polarity functional layer group 160 is electrically connected the second polarity functional layer group 130 in other manners.

Specifically, the second polarity functional layer group 130 may be disposed on the second region 102 in a stacked manner, and the third polarity functional layer group 160 may be disposed on the connection region 104 in a stacked manner. At the first preset position, the third polarity functional layer group 160 has the wrapping portion covering the extending portion of the first polarity functional layer group 120 in a stacked manner and extending to cover the first polarity functional layer group 120. The extending portion has a surface facing the connection region 104, a surface facing away from the connection region 104, and a sidewall connecting the two surfaces, and the third polarity functional layer group 160 is stacked on a bottom surface of the connection region 104 and a sidewall between the connection region 104 and the first region 101 and extends to be stacked on the extending portion, that is, the third polarity functional layer group 160 wraps around the surface of the extending portion facing the connection region 104, the surface facing away from the connection region 104, and the sidewall connecting the two surfaces in a stacked manner. At least a portion of the wrapping portion forms a composite contact with the first polarity functional layer group 120. Specifically, the wrapping portion may form a composite contact with the surface of the first polarity functional layer group 120 facing the connection region 104, the wrapping portion may form a composite contact with the surface of the first polarity functional layer group 120 facing the connection region 104 and the sidewall connecting the two surfaces, or the wrapping portion may form a composite contact with other positions of the first polarity functional layer group 120, which is not limited herein.

It is to be noted that, herein, "composite contact" means that there is no insulation between the first polarity functional layer group 120 and the third polarity functional layer group 160, but leakage conduction forms a leakage channel. Specifically, the doped layer in the first polarity functional layer group 120 may be in direct contact with the doped layer in the third polarity functional layer group 160 to form a leakage channel, or tunneling may be achieved through other dielectric layers to achieve the function of composite contact, which is not specifically limited herein.

When a hot spot occurs, the resistance of a faulty cell piece increases, and the current is difficult to pass normally. The existence of the leakage channel provides an additional flow path for current. A portion of the current may bypass the faulty cell piece through the leakage channel, thereby avoiding a large amount of current from concentrating in a hot spot region and reducing the heating power in the region.

The leakage channel may also play a role in balancing the voltage between the batteries. In a case of the hot spot, the voltages of two ends of the faulty cell piece may change, thereby forming a voltage difference with other normal cell pieces. Due to the existence of the leakage channel, the current can be adjusted between different cell pieces, so that the voltage of each cell piece is more balanced. In this way, the voltage difference between the cell pieces may be reduced, the possibility of hot spot occurrence may further be reduced, and the stability and reliability of the entire solar cell 100 assembly may be improved.

It is to be noted that, in the embodiments of the present disclosure, when the first region 101 and the second region 102 are adjacently disposed, the "first preset position" is located in the second region 102, and when other regions are disposed between the first region 101 and the second region 102, the "first preset position" is located in the connection region 104. The "first preset position" may be understood as the entire connection region 104 or the second region 102, or may be understood as a portion of the position of the connection region 104 or the second region 102, which is not specifically limited herein. In some embodiments, the first preset position is preferably a portion of the position of the connection region 104 or the second region 102. In such a case, the number of the first preset positions may be singular or plural in each connection region 104 or the second region 102, and in the single connection region 104 or the second region 102, the plurality of first preset positions may be disposed at intervals perpendicular to the arrangement direction of the first region 101 and the second region 102, which is not specifically limited herein.

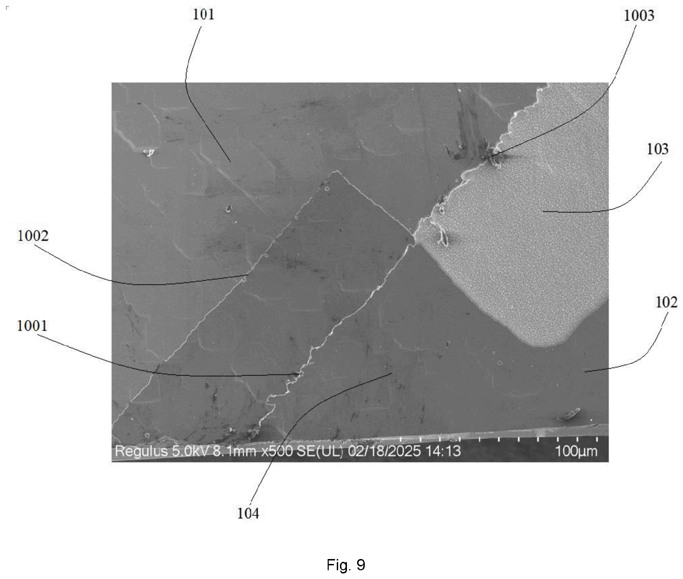

As shown in Fig. 9, the edge of the wrapping portion closest to the connection region 104 is the first boundary line 1001, and the wrapping portion wraps around and covers the extending portion in a stacked manner, that is, the wrapping portion wraps around the surface of the extending portion facing the connection region 104, the surface facing away from the connection region 104, and the sidewall connecting the two surfaces in a stacked manner, and an outer contour (a contour facing away from the sidewall) of the wrapping portion stacked on the sidewall connecting the two surfaces is the first boundary line 1001.

The first boundary line 1001 is the outer contour of the wrapping portion, an inner contour of the wrapping portion corresponds to the outer contour, and the inner contour of the wrapping portion is in composite contact with the first polarity functional layer group 120. It may be understood that the thickness of the third polarity functional layer group 160 is relatively uniform, and the outer contour corresponds to the inner contour. Therefore, the more rugged the outer contour, the more rugged the inner contour. The smoother the outer contour, the smoother the inner contour.

The edge of the wrapping portion farthest away from the connection region 104 is the second boundary line 1002, the wrapping portion extends to cover the first polarity functional layer group 120, and the edge extending toward the first region 101 and away from the connection region 104 is the second boundary line 1002.

The degree of undulation of the first boundary line 1001 is greater than that of the second boundary line 1002. The degree of undulation is an indicator for describing the irregularity or fluctuation of the edge of an object. In the context of the structure of the solar cell 100, the degree of undulation is specifically configured to measure the irregular shape characteristics of the first boundary line 1001 and the second boundary line 1002 of the wrapping portion.

The edge of the wrapping portion is not an absolutely smooth and straight line, but has variations in height and curvature. The higher the degree of undulation is, the more pronounced such variations in height and curvature of the edge, resulting in more irregular and violently fluctuating lines. The lower the degree of undulation, the relatively smoother and closer to a straight-line state the edge.

On the one hand, the first boundary line 1001 is the edge of the wrapping portion closest to the connection region, and the high degree of undulation of the first boundary line 1001 indicates that the boundary exhibits a complex and uneven shape. Since the inner contour of the wrapping portion is in composite contact with the first polarity functional layer group 120, and the thickness of the third polarity functional layer group 160 is relatively uniform, the degree of undulation of the outer contour corresponds to that of the inner contour, so that the contact area between the third polarity functional layer group 160 and the first polarity functional layer group 120 is significantly increased. The photo-generated carriers can be more efficiently collected into the third polarity functional layer group 160, which indicates that during the operation of the cell, charges can be conducted more smoothly, thereby reducing the problem of local overheating caused by charge accumulation and improving the hot spot effect.

On the other hand, when the degree of undulation of the second boundary line 1002 is low, the contact area between the third polarity functional layer group 160 and the first polarity functional layer group 120 decreases, which indicates that those contact regions that may cause parasitic absorption become smaller inside the cell,. At some unnecessary contact interfaces, light scattering, reflection, or other ineffective absorption processes may occur. Reducing the contact area may reduce the probability of these parasitic absorption phenomena, so that more light energy can be configured to generate the photo-generated carriers, thereby improving conversion efficiency.

Specifically, during observation, an enlarged microscopic top view of the solar cell may be observed. Since the first boundary line 1001 and the second boundary line 1002 are both outer layer contours of the third polarity functional layer group 160, the first boundary line 1001 and the second boundary line 1002 of the solar cell form obvious contour lines on the cell. As shown in Fig. 9, the contour lines formed in the top view are the first boundary line 1001 and the second boundary line 1002.

In the present embodiment, the first region 101 and the second region 102 are alternately distributed on the backlight surface of the solar cell 100, and connected through the connection region 104. The first polarity functional layer group 120 is located in the first region 101, and has the extending portion that partially extends beyond the first region 101 at a specific position. The third polarity functional layer group 160 is disposed on the connection region 104, and partially forms the wrapping portion covering the extending portion and extending to the first polarity functional layer group 120. The edge of the wrapping portion close to the connection region 104 is the first boundary line 1001, the edge away from the connection region 104 is the second boundary line 1002, and the degree of undulation of the first boundary line 1001 is greater than that of the second boundary line 1002. The degree of undulation of the first boundary line 1001 is high, thereby increasing the contact area between the third polarity functional layer group 160 and the first polarity functional layer group 122 and improving the hot spot effect, so that the photo-generated carriers are more efficiently collected into the third polarity functional layer group 160 and transported to an electrode, thereby improving the short-circuit current and photoelectric conversion efficiency. The degree of undulation of the second boundary line 1002 is low, thereby reducing the contact area with the first polarity functional layer group 120, decreasing the parasitic absorption, and improving the conversion efficiency. At the same time, the recombination of the carriers at the boundary may be reduced and the collection efficiency may be improved.

As shown in Fig. 9, in some embodiments, the adjacent first region 101 and the second region 102 are separated by a groove region 103, a portion of the second region 102 is connected to the first region 101 through the connection region 104, an edge of the first polarity functional layer group 120 closest to the groove region 103 is a third boundary line, and the degree of undulation of the third boundary line 1003 is greater than that of the first boundary line 1001.

The groove region 103 is disposed between the first region 101 and the second region 102. The groove region 103 is a region where a groove is disposed. The groove region 103 is in a recessed state compared to the surfaces of the first region 101 and the second region 102. The first region 101 and the second region 102 are spatially separated, thereby achieving electrical isolation between the first region 101 and the second region 102, and avoiding current interference between the adjacent first region 101 and the second region 102.

The groove region 103 is disposed between the adjacent first region 101 and the second region 102 for isolating the first region 101 from the second region 102. The connection region 104 is a portion of the second region 102 extending toward the first region 101, that is, the second region 102 extends toward the first region 101 to form the connection region 104, which is located between the first region 101 and the second region 102, and is configured to connect the first region 101 and the second region 102, which are isolated by the groove region 103, that is, no groove is disposed in the connection region 104, and the first region 101 and the second region 102 are connected.

The third boundary line 1003 is the edge of the first polarity functional layer group 120 on a side facing the groove region 103, and the boundary between the first polarity functional layer group 120 and the groove region 103 is the third boundary line 1003 in a plan view of the solar cell 100.

The main function of the groove region 103 is to isolate the first region 101 from the second region 102, thereby preventing unnecessary current leakage therebetween. The higher the degree of undulation of the third boundary line 1003, the more complex and tortuous the contact boundary between the third boundary line and the groove region 103. In this way, the difficulty of current flowing from the first polarity functional layer group 120 across the groove region 103 to the second region 102 is increased, which is equivalent to prolonging the leakage path. When the current passes through such a complex boundary, it may encounter more obstacles, thereby effectively reducing the possibility of leakage and improving the electrical isolation performance of the cell.

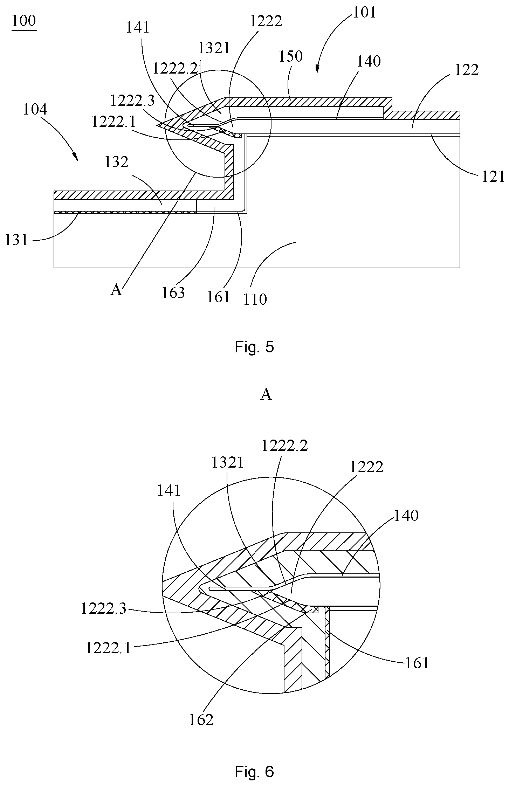

As shown in Fig. 5 to Fig. 7, in some embodiments, the first polarity functional layer group 120 includes a first dielectric layer 121 and a first polarity doped layer 122, the second polarity functional layer group 130 includes a second dielectric layer 131 and a second polarity doped layer 132, and the third polarity functional layer group 160 includes a third dielectric layer 161, a fourth dielectric layer 162, and a third polarity doped layer 163.

The first dielectric layer 121 is disposed on the first region 101 in a stacked manner, the first polarity doped layer 122 is disposed on the first dielectric layer 121 in a stacked manner, at the first preset position, along an arrangement direction of the connection region 104 and the first region 101, the first polarity doped layer 122 has a first extending portion 1222 extending above the connection region 104, and the first extending portion 1222 has a first surface 1222.1 facing the connection region 104 and a second surface 1222.2 facing away from the connection region 104.

The second dielectric layer 131 is disposed on the second region 102 in a stacked manner, and the second polarity doped layer 132 is disposed on the second dielectric layer 131 in a stacked manner.

The third dielectric layer 161 is disposed on the connection region 104 in a stacked manner, the fourth dielectric layer 162 is disposed on at least a portion of the first surface 1222.1, the fourth dielectric layer 162 has a tunneling function, the third polarity doped layer 163 is disposed on the third dielectric layer 161 and the fourth dielectric layer 162 in a stacked manner, the third polarity doped layer 163 on the third dielectric layer 161 is connected to the third polarity doped layer 163 on the fourth dielectric layer 162, the third polarity doped layer 163 has a first wrapping portion 1631 at the first preset position, and the first wrapping portion 1631 wraps around an end of the first extending portion 1222 and a second surface 1222.2 of the first extending portion 1222 and extends to the first region 101.

The first polarity functional layer group 120 includes the first dielectric layer 121 and the first polarity doped layer 122, the first dielectric layer 121 is disposed on the first region 101 in a stacked manner, and the first polarity doped layer 122 is disposed on the first dielectric layer 121 in a stacked manner. Specifically, the first dielectric layer 121 may be in direct contact with the first polarity doped layer 122, or other functional layers may further be disposed between the first dielectric layer 121 and the first polarity doped layer 122. The first dielectric layer 121 may be a tunneling layer, such as a silicon oxide tunneling layer and other film layers having passivation and tunneling functions, and the specific type thereof may be selected according to the actual situation, which is not specifically limited herein.

At the first preset position, along the arrangement direction of the connection region 104 and the first region 101, the first polarity doped layer 122 has the first extending portion 1222 extending above the connection region 104, and the first extending portion 1222 has the first surface 1222.1 facing the connection region 104 and the second surface 1222.2 facing away from the connection region 104. In the present embodiment, at least some functional layers in the first polarity functional layer group 120 have the extending portion extending above the connection region 104, that is, the first polarity doped layer 122 in the first polarity functional layer group 120 has the extending portion extending above the connection region 104.

The second polarity functional layer group 130 includes the second dielectric layer 131 and the second polarity doped layer 132, the second dielectric layer 131 is disposed on the second region 102 in a stacked manner, and the second polarity doped layer 132 is disposed on the second dielectric layer 131 in a stacked manner.

The third dielectric layer 161 is disposed on the connection region 104 in a stacked manner, and the fourth dielectric layer 162 is disposed on at least a portion of the first surface 1222.1, that is, the fourth dielectric layer 162 completely or partially covers the first surface 1222.1. The third dielectric layer 161 is stacked on the connection region 104, that is, when the first region 101 and the second region 102 are adjacently disposed, the third dielectric layer 161 is disposed on the sidewall between the first region 101 and the second region 102. When other regions (such as the groove region 103) are disposed between the first region 101 and the second region 102, the third dielectric layer 161 may be disposed only on the bottom surface of the connection region 104, or may be disposed on the bottom surface of the connection region 104 and extend toward the sidewall between the connection region 104 and the first region 101. Specifically, the third dielectric layer 161 on the sidewall between the connection region 104 and the first region 101 may be connected or disconnected to the fourth dielectric layer 162, which is not limited herein. The fourth dielectric layer 162 has a tunneling function. The fourth dielectric layer 162 may be an oxide layer, such as a silicon oxide film layer and other film layers having passivation functions, and has a tunneling function at a position covering the first surface 1222.1, and the specific type thereof may be selected according to the actual situation, which is not specifically limited herein.

The second polarity doped layer 132 is disposed on the third dielectric layer 161 and the fourth dielectric layer 162 in a stacked manner, and the second polarity doped layer 132 on the third dielectric layer 161 is connected to the second polarity doped layer 132 on the fourth dielectric layer 162, that is, the second polarity doped layer 132 stacked on the second dielectric layer 131 and the third dielectric layer 161 is not interrupted regardless of whether the second dielectric layer 131 is connected to the third dielectric layer 161 or not. Specifically, the second polarity doped layer 132 may be in direct contact with the third dielectric layer 161 and the fourth dielectric layer 162, respectively, or other functional layers may be disposed between the second polarity doped layer 132 and the third dielectric layer 161 and the fourth dielectric layer 162, respectively, which is not limited herein. The second polarity doped layer 132 has the first wrapping portion 1631, the first wrapping portion 1631 wraps around the end of the first extending portion 1222 and the second surface 1222.2 of the first extending portion 1222 and extends to the first region 101.

Specifically, at the first preset position in the connection region 104, the first wrapping portion 1631 may wrap around the first surface 1222.1, the end, and the second surface 1222.2 of the entire first extending portion 1222, that is, the first wrapping portion 1631 may extend along a side surface of the connection region 104 to cover the second dielectric layer 131, wrap around the end of the first extending portion 1222, and extend to cover the second surface 1222.2 of the first extending portion 1222, or even extend to cover the first polarity doped layer 122 partially disposed on the first region 101. In this case, an insulating medium may be disposed between the first wrapping portion 1631 and the second surface 1222.2, such as a silicon oxide layer or a silicon nitride layer with an insulating function. When the second dielectric layer 131 only covers a portion of the first surface 1222.1, the first surface 1222.1 not covered with the second dielectric layer 131 is covered with the second polarity doped layer 132, and the connection between the second polarity doped layer 132 located on the second surface 1222.2 and the second polarity doped layer 132 located on the second dielectric layer 131 is not interrupted.

In the present embodiment, the outer contour of the second polarity doped layer 132 wrapping around the first extending portion may be the first boundary line 1001, and the edge of the second polarity doped layer 132 extending to the first region 101 may be the second boundary line 1002.

In the present disclosure, the silicon substrate 110 may be a P-type silicon substrate 110 or an N-type silicon substrate 110, preferably the N-type silicon substrate 110, which is not specifically limited herein.

In one possible embodiment, during the manufacturing, cleaning and texturing processes are first performed on the silicon substrate 110, and then the first dielectric layer 121 is deposited on the entire backlight surface of the silicon substrate 110. Then, the first polarity doped layer 122 is deposited on the first dielectric layer 121. Then, a portion of the first polarity doped layer 122 and the first dielectric layer 121 are removed by etching, and a portion of the silicon substrate 110 is removed on the backlight surface at the corresponding position. The unetched portion is the first region 101, so that the surface of the silicon substrate 110 of the first region 101 and the surfaces of the silicon substrate 110 of other regions (the connection region 104, the second region 102, and the groove region 103) have a height difference, and the first extending portion 1222 of the first polarity doped layer 122 at the first predetermined position extends above the connection region 104. For example, in one possible embodiment, a portion of a recess is first formed by laser or etching, and then the area of the recess is laterally expanded by etching, so that the first polarity doped layer 122 has the first extending portion 1222 extending above the connection region 104.

Subsequently, the second dielectric layer 131 may be deposited on the surfaces and sidewalls of the regions other than the first region 101, and the first surface 1222.1 of the first extending portion 1222. Then, the second polarity doped layer 132 may be deposited by deposition, so that the second polarity doped layer 132 covers the second dielectric layer 131 in a stacked manner and has the first wrapping portion 1631 at the first preset position, and the first wrapping portion 1631 wraps around the end of the first extending portion 1222 and the second surface 1222.2 of the first extending portion 1222 and extends to the first region 101.

Finally, the second polarity doped layer 132 and the second dielectric layer 131 of the groove region 103 are removed again by etching or the like, and a portion of the silicon substrate 110 is removed on the backlight surface at the corresponding position, so that the surface of the silicon substrate 110 of the groove region 103 and the surface of the silicon substrate 110 of the connection region 104 and the second region 102 have a height difference to form a groove.

As shown in Fig. 2, in some embodiments, the first polarity doped layer 122 is disposed on the first region 101 in a stacked manner, and the first polarity doped layer 122 has a first edge 1004 and a second edge 1005.

The second polarity doped layer 132 is disposed on the second region 102 in a stacked manner, the third polarity doped layer 163 is disposed on the connection region 104 in a stacked manner, the third polarity doped layer 163 is in composite contact with the first polarity doped layer 122 of the connection region 104, and the second polarity doped layer 132 disposed on the second region 102 has a third edge 1006.

The plane where the second region 102 is located is a first plane, the first edge 1004 and the third edge 1006 are oppositely disposed on both sides of the groove region 103, the second edge 1005 is close to a composite contact position of the second polarity doped layer 132 and the first polarity doped layer 122, and a projection distance of an extending line from the second edge 1005 to the third edge 1006 on the first plane is smaller than a projection distance from the first edge 1004 to the third edge 1006 on the first plane.

The first polarity doped layer 122 is disposed on the first region 101 in a stacked manner, and the first polarity doped layer 122 may be in direct contact with the first region 101 of the silicon substrate 110, or other functional layers, such as a tunneling functional layer, may be disposed between the first polarity doped layer 122 and the silicon substrate 110. The first polarity doped layer 122 has two edges, namely the first edge 1004 and the second edge 1005, respectively, an edge facing the groove region 103 is the first edge 1004, and an edge facing the connection region 104 is the second edge 1005. The second edge 1005 may specifically be an edge of the first extending portion 1222 on a side close to the connection region.

The second polarity doped layer 132 is disposed on the second region 102 and the connection region 104 in a stacked manner, and the second polarity doped layer 132 may be in direct contact with the second region 102 and the connection region 104 of the silicon substrate 110, or other functional layers, such as a tunneling functional layer, may be disposed between the second polarity doped layer 132 and the silicon substrate 110. The second polarity doped layer 132 has a third edge 1006, and the third edge 1006 is disposed on the other side of the groove region 103 and opposite to the first edge 1004 on the side of the groove region 103.

The plane where the second region 102 is located is the first plane. In fact, the surface of the second region 102 may have a concave-convex microstructure, which is not an absolute plane, but the first plane is a general planar concept. It may be understood as a plane determined on a macroscopic scale based on the overall distribution of the second region 102, ignoring minor concave-convex undulations on the surface thereof. This plane provides a uniform reference for subsequent descriptions of the distance relationships between the edges.

The projection distance of the extending line from the second edge 1005 to the third edge 1006 on the first plane is smaller than the projection distance from the first edge 1004 to the third edge 1006 on the first plane. In the structure of the solar cell 100, the first edge 1004, the second edge 1005, and the third edge 1006 are substantially parallel, and when determining the distance between the edges, the surface undulations thereof are ignored, and the projection of each edge on the first plane is approximately regarded as a straight line along the extending direction of each edge.

The projection of the extending line of the third edge 1006 on the first plane is the extending line of the projection of the third edge 1006 on the first plane.

On the first plane, projection lines of the edges are parallel or approximately parallel (an angle difference is small, usually not greater than 2°). It may be understood that the projection line of each edge may not be an absolute straight line, and each projection line may be approximately regarded as a straight line. The projection distance of the extending line from the second edge 1005 to the third edge 1006 on the first plane is denoted as L1. Since the third edge 1006 and the second edge 1005 are not in opposite positions but are staggered, a projection distance from the second edge 1005 to the third edge 1006 on the first plane is the projection distance of the extending line from the second edge 1005 to the third edge 1006 on the first plane, namely a vertical distance between the projection line of the second edge 1005 and the projection line of the third edge 1006 on the first plane. The projection distance from the first edge 1004 to the third edge 1006 on the first plane is a vertical distance between the projection lines from the first edge 1004 to the third edge 1006 on the first plane, and is denoted as L2, where L1<L2.

It may be understood that the vertical distance is the shortest distance. A common perpendicular line (a straight line that intersects with two straight lines perpendicularly) of two parallel straight lines is found, and the length of a common perpendicular line segment is the vertical distance between the two parallel straight lines.

The projection distance of the extending line from the second edge 1005 to the third edge 1006 on the first plane is smaller than the projection distance from the first edge 1004 to the third edge 1006 on the first plane, which indicates that the composite contact position is relatively closer to the first region 101, and the distance between the first region 101 and the second region 102 achieves a relatively balanced state through the arrangement.

In the solar cell 100, the recombination of the carriers (electrons and holes) is one of the important factors affecting the cell efficiency. When the composite contact position is equidistant from the first region 101 and the second region 102, a transport path of the carriers may be optimized. Since the composite contact position is closer to the first region 101, the carriers generated by the first polarity doped layer 122 may be transported to the third polarity doped layer 163 more quickly through a composite contact region, so as to reduce the probability of the carriers recombining with other impurities or defects during the transport, thereby improving the collection efficiency of the carriers and reducing the energy loss.

As shown in Fig. 1, in some embodiments, the third edge 1006 is flush with an edge of the second region 102.

The groove region 103 and the second region 102 are adjacently disposed, the edge of the second region 102 is an edge of the groove region 103, and a boundary line between the surface of the second region 102 on the silicon substrate 110 and the groove region 103.

The third edge 1006 is the boundary of the side of the second polarity doped layer 132 facing the groove region 103, and the two edges being flush indicates that the two boundaries are located in the same spatial position, that is, the projection distance between the third edge 1006 and the edge of the second region 102 on the first plane is 0.

This structural design may improve the compactness and regularity of the internal structure of the cell, facilitate the uniform conduction of current, and reduce the resistance loss, thereby improving the photoelectric conversion efficiency of the cell.

As shown in Fig. 2, in some embodiments, the third edge 1006 is at a preset distance from the edge of the second region 102.

The third edge 1006 is at a preset distance L3 from the edge of the second region 102, and the second polarity doped layer 132 does not have a portion extending above the groove region 103, so that the distance between the third edge 1006 and the edge of the second region 102 is a distance L3 by which the third edge 1006 is recessed relative to the edge of the second region 102.

The second polarity doped layer 132 is disposed at the preset distance L3 from the edge of the groove region 103 (that is, a platform region is disposed between the second polarity doping layer 132 and the groove region 103), the outermost layer of the backlight surface usually covers a passivation film layer, and the formed platform region may increase the mobile hydrogen content of the local passivation film layer on the upper layer of a space charge region, thereby enhancing the hydrogen passivation in this region, reducing the recombination of the space charge region, and improving the cell performance.

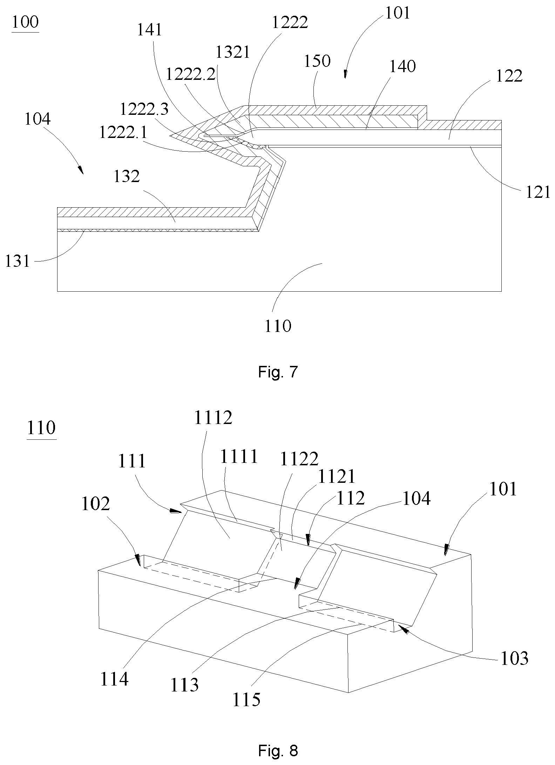

As shown in Fig. 8, in some embodiments, the silicon substrate 110 has a first notch 111 recessed toward the first region 101 between the first region 101 and the groove region 103, the first notch 111 has a first sidewall 1111 and a second sidewall 1112, the first sidewall 1111 is farther away from the light-receiving surface than the second sidewall 1112, and the first sidewall 1111 and the surface of the first region 101 form a first included angle.

A distance between the surfaces of the second region 102 and the connection region 104 and the bottom of the groove region 103 is smaller than a distance between the surface of the first region 101 and the bottom of the groove region 103, a second notch 112 recessed toward the first region 101 is disposed between the first region 101 and the connection region 104, the second notch 112 has a third sidewall 1121 and a fourth sidewall 1122, the third sidewall 1121 is farther away from the light-receiving surface than the fourth sidewall 1122, and the second sidewall 1112 and the surface of the first region 101 have a second included angle.

The first included angle is smaller than the second included angle.

The distance between the surfaces of the second region 102 and the connection region 104 and the bottom of the groove region 103 is smaller than the distance between the surface of the first region 101 and the bottom of the groove region 103, that is, the heights of the regions on the silicon substrate 110 are stepped, with height differences between the regions. The bottom of the groove region 103 is the lowest, the surfaces of the second region 102 and the connection region 104 are higher than the bottom of the groove region 103, and the surface of the first region 101 is higher than the surfaces of the second region 102 and the connection region 104.

The silicon substrate 110 of the first region 101 has the first notch 111 recessed toward the first region 101 between the first region 101 and the groove region 103, and the region has the first sidewall 1111 and the second sidewall 1112. The first notch 111 is a lateral notch formed by a sidewall between the groove region 103 and the first region 101 recessed inward, and the intersection position of the first sidewall 1111 and the second sidewall 1112 is the notch bottom of the first notch 111. The first sidewall 1111 is farther away from the light-receiving surface than the second sidewall 1112, that is, the first sidewall 1111 is closer to the surface of the first region 101 than the second sidewall 1112, and the first sidewall 1111 and the surface of the first region 101 form the first included angle.

The silicon substrate 110 of the first region 101 has the second notch 112 recessed toward the first region 101 between the first region 101 and the connection region 104, and the region has the third sidewall 1121 and the fourth sidewall 1122. The second notch 112 is a lateral notch formed by a sidewall between the connection region 104 and the first region 101 recessed inward, and the intersection position of the third sidewall 1121 and the fourth sidewall 1122 is the notch bottom of the second notch 112. The third sidewall 1121 is farther away from the light-receiving surface than the fourth sidewall 1122, that is, the third sidewall 1121 is closer to the surface of the first region 101 than the fourth sidewall 1122, and the third sidewall 1121 and the surface of the first region 101 form the second included angle.

If the first included angle is smaller than the second included angle, and the included angle formed by the first sidewall 1111 and the surface of the first region 101 is smaller than the included angle formed by the third sidewall 1121 and the surface of the first region 101, then the depth of the first notch 111 is greater than that of the second notch 112.

The greater the depth of the first notch 111, the more complex the internal spatial structure. When light irradiates the surface of the solar cell 100 and enters the first notch 111, the light may undergo more reflections inside the notch due to the deeper notch. Each reflection may give the light more opportunities to be absorbed by a cell material, which is equivalent to increasing the effective absorption area of the cell for light. For example, light that originally directly irradiates on the surface of the cell may only undergo one absorption process, but after multiple reflections inside the first notch 111, the light may be absorbed at different angles and positions, so that more light is utilized by the cell.

The deeper first notch 111 can also expand the range of a light-receiving angle of the cell. Light incident at different angles is more likely to enter the inside of the first notch 111. Compared with a shallow notch or planar structure, more light from different directions can be captured. In practical applications, the position of the sun changes over time and seasons, and the angle of incidence of light changes accordingly. The deep structure of the first notch 111 may enable the cell to better absorb light under different illumination conditions, thereby further increasing the absorption area of light.

In the present embodiment, if the first included angle is smaller than the second included angle, the depth of the first notch 111 is greater than that of the second notch 112. The position of the first notch 111 corresponds to the groove region 103, and light is not utilized in the groove region 103, so that a deeper first notch 111 facilitates an increase in the absorption area of light. The second notch 112 corresponds to the connection region 104, and the second polarity doped layer 132 is stacked on the connection region 104 to absorb and utilize light. The depth of the second notch 112 is relatively shallow, so that the unabsorbed light in the second notch 112 may be absorbed and utilized on the second polarity doped layer 132.

As shown in Fig. 8, in some embodiments, the second sidewall 1112 and the bottom of the groove region 103 form a first bottom edge 113. The fourth sidewall 1122 and the surface of the connection region 104 form a second bottom edge 114. The second region 102 and the bottom of the groove region 103 have a third bottom edge 115.

A projection distance from the first bottom edge 113 to the third bottom edge 115 on the first plane is greater than a projection distance from the second bottom edge 114 to the third bottom edge 115 on the first plane.

The second sidewall 1112 and the bottom of the groove region 103 form the first bottom edge 113, the fourth sidewall 1122 and the surface of the connection region 104 form the second bottom edge 114, the second region 102 and the bottom of the groove region 103 have the third bottom edge 115, and the first bottom edge 113 and the third bottom edge 115 are two boundaries of a bottom surface of the groove region 103. Typically, the first bottom edge 113, the second bottom edge 114, and the third bottom edge 115 are substantially parallel, and when determining the distance between the bottom edges, the surface undulations thereof are ignored, and the projection of each edge on the first plane is approximately regarded as a straight line along the extending direction of the edges, so that the projections of the first bottom edge 113, the second bottom edge 114, and the third bottom edge 115 on the first plane are parallel.

The projection distance from the first bottom edge 113 to the third bottom edge 115 on the first plane is denoted as S1, and the projection distance from the second bottom edge 114 to the third bottom edge 115 on the first plane is denoted as S2, where S1>S2.

S1 corresponds to the groove region 103, and the main function of the groove region 103 is to achieve electrical isolation between different regions of the cell and prevent the occurrence of leakage phenomenon. When S1 is larger, it indicates that the effective isolation distance of the groove region 103 on the projection plane is longer. Leakage is typically caused by the carriers (electrons or holes) flowing along an undesired path, and the longer isolation distance increases the difficulty for the carriers to cross the groove region 103, which is equivalent to increasing the resistance of the leakage. The leakage between different regions inside the cell is effectively reduced and the stability of the electrical performance of the cell is improved.

S2 corresponds to the connection region 104, and the function of the connection region 104 is to achieve the electrical connection between different parts of the cell, so that the carriers can be smoothly transported between different regions. When S2 is smaller, it indicates that the distance of the connection region 104 is shorter, and the transport path of the carriers in the connection region 104 is shorter. The shorter transport path may reduce the energy loss and recombination probability of the carriers during the transport, thereby ensuring good electrical contact between different regions of the cell, and reducing the contact resistance. The lower contact resistance facilitates an improvement in the filling factor and output power of the cell, so that the cell can convert the light energy into the electrical energy output more efficiently.

In the present embodiment, the projection distance from the first bottom edge 113 to the third bottom edge 115 on the first plane is greater than the projection distance from the second bottom edge 114 to the third bottom edge 115 on the first plane, and the isolation performance of the groove region 103 and the contact performance of the connection region 104 are optimized by the distance, respectively, thereby improving the photoelectric conversion efficiency, stability of the electrical performance, and overall reliability of the solar cell 100.

In some embodiments, the solar cell 100 may further include a first electrode and a second electrode, both of which are metal electrodes. A passivation film layer may further be disposed on the backlight surface of the silicon substrate 110, and the passivation film layer covers the entire backlight surface (that is, the passivation film layer as the outermost film layer covers all the sub-outer film layers on the backlight surface, and the sub-outer film layers of the first region 101 and the sub-outer film layers of the second region 102 are partially different). The first electrode is located in the first region 101 and penetrates through the passivation film layer to form an ohmic contact with the first polarity doped layer 122 and is insulated and isolated from the second polarity doped layer 132. For example, when the wrapping portion extends to cover the extending portion and covers a portion of the first polarity doped layer 122 on the first region 101, the first electrode may be located at a position where the first polarity doped layer 122 is not wrapped and covered by the wrapping portion, and the second electrode may be located at the second region 102 and penetrate through the passivation film layer to form an ohmic contact with the second polarity doped layer 132.

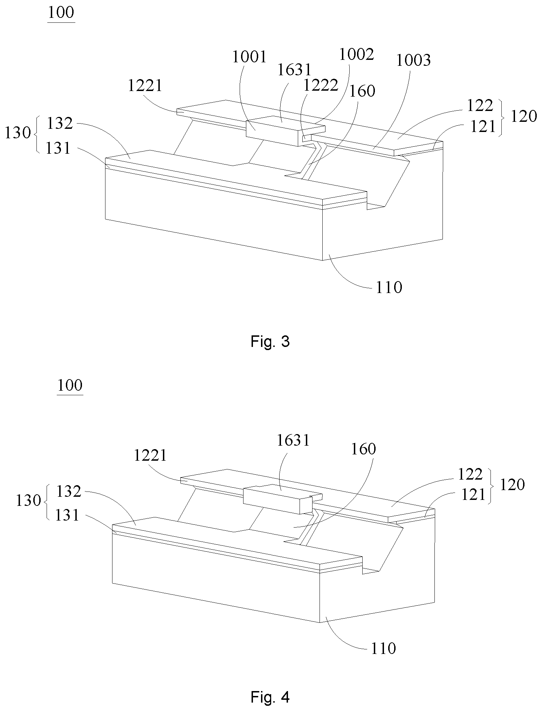

As shown in Fig. 4, in some embodiments, at the first preset position, the first wrapping portion 1631 wraps around the sidewalls on both sides of the end of the first extending portion 1222.

The first extending portion 1222 has two opposite sidewalls, and the first wrapping portion 1631 wraps around the sidewalls on both sides of the end of the first extending portion 1222, that is, except for a connecting portion between the first extending portion 1222 and the first polarity doped layer 122, the remaining extending portions are all wrapped by the first wrapping portion 1631.

The first wrapping portion 1631 wraps around the sidewalls on both sides of the end of the third extending portion 1221, so that the contact area between the second polarity doped layer 132 and the third extending portion 1221 is greatly increased. The more contact area provides more composite contact transport channels for the carriers, thereby further reducing the contact resistance.

In some embodiments, an insulating layer 140 is disposed between the wrapping portion and the second surface 1222.2.

The wrapping portion is a portion of the second polarity doped layer 132, the second surface 1222.2 is a surface of the first polarity doped layer 122, and the insulating layer 140 is disposed between the wrapping portion and the second surface 1222.2, that is, the second polarity doped layer 132 and the first polarity doped layer 122 are disposed in a stacked manner at this position, and the insulating layer 140 is disposed between the first polarity doped layer 122 and the second polarity doped layer 132. The insulating layer 140 may isolate the electrical connection between the first polarity doped layer 122 and the second polarity doped layer 132 to avoid unnecessary current leakage and interference.

In the present embodiment, the insulating layer 140 is disposed to prevent the unnecessary flow of the electrons between the wrapping portion and the first extending portion 1222, and reduce the current leakage, so that the electric field distribution inside the cell is more reasonable, and the carriers can be collected and transported to the electrodes more efficiently, thereby improving the open circuit voltage and filling factor, and further improving the photoelectric conversion efficiency of the cell.

In some embodiments, the insulating layer 140 has a second extending portion 141 protruding from the first extending portion 1222 along the arrangement direction of the connection region 104 and the first region 101.

The insulating layer 140 is not only disposed between the wrapping portion and the second surface 1222.2, but also has the second extending portion 141 protruding from the first extending portion 1222 along the arrangement direction of the connection region 104 and the first region 101. The second extending portion 141 further enhances the insulation and isolation effects, and expands the insulation range.

Assuming that the length of the first extending portion 1222 is 80 nanometers, the second extending portion 141 of the insulating layer 140 protrudes further 20-30 nanometers from the first extending portion 1222. In this way, the current leakage can be better prevented at the junction of the connection region 104 and the first region 101.

In the present embodiment, the second extending portion 141 increases the coverage of the insulating layer 140, particularly at the edge of the connection region 104 and the first region 101, thereby reducing the possibility of electric field concentration and current leakage at the edge. This helps protect the edge structure of the cell and prevent the cell performance degradation and shortened life due to edge leakage, thereby improving the reliability and stability of the cell.

As shown in Fig. 5 to Fig. 7, in some embodiments, the first surface 1222.1 and the second surface 1222.2 intersect at the end of the first extending portion 1222 to form a tip portion 1222.3, and the wrapping portion wraps around the tip portion 1222.3.

Since the end of the first extending portion 1222 is pointed, even if the first wrapping portion 1631 wraps around the tip portion 1222.3, the first wrapping portion 1631 is only in linear surface contact with a tip of the tip portion 1222.3, so that the contact area between the end of the first extending portion 1222 and the first wrapping portion 1631 may be reduced, and the recombination can be reduced.

Of course, it may be understood that, in some embodiments, the end of the first extending portion 1222 may not form a tip, that is, the first surface 1222.1 may be connected to the second surface 1222.2 through an end surface. In such a case, the first wrapping portion 1631 may wrap around the end surface of the first extending portion 1222. When the first wrapping portion 1631 wraps around the end surface of the first extending portion 1222, a dielectric layer may or may not be disposed between the end surface and the first wrapping portion 1631. When the dielectric layer is disposed, the dielectric layer may be a film layer such as a metal oxide layer or an intrinsic silicon layer, which is not specifically limited herein.

In some embodiments, an end of the tip portion 1222.3 has a hole.

In this way, the end of the tip portion 1222.3 has the hole, so that the contact area between the first wrapping portion 1631 and the end of the tip portion 1222.3 may be reduced, thereby reducing the recombination.

In some embodiments, a distance from the surface of the first polarity doped layer 122 to the light-receiving surface is H1, a distance from the surface of the second polarity doped layer 132 to the light-receiving surface is H2, and a distance from the surface of the groove region 103 to the light-receiving surface is H3, where H1>H2>H3.

That is, when the solar cell 100 is placed horizontally toward the light-receiving surface downward, the surface of the first polarity doped layer 122 is higher than the surface of the second polarity doped layer 132 in the second region 102, and the surface of the second polarity doped layer 132 in the second region 102 is higher than the surface of the groove region 103.

Different distance settings allow light to be better absorbed by different doped layers and regions after entering the cell. H3 is the smallest, and the groove region 103 is closer to the light-receiving surface. When light irradiates the surface of the cell, it first reaches the groove region 103. Although the groove region 103 does not perform photoelectric conversion, it may scatter and refract light. In this way, a propagation path of light inside the cell can be more complex and diversified, and a propagation distance of light in the first polarity doped layer 122 and the second polarity doped layer 132 can be increased, thereby improving the absorption efficiency of light by these two layers.

The second polarity doped layer 132 is closer to the light-receiving surface than the first polarity doped layer 122 (H2<H1) to absorb a portion of the shorter-wavelength light first, while the first polarity doped layer 122 may absorb the remaining longer wavelength light. This layered absorption manner allows the cell to make more full use of different wavelengths of sunlight, thereby improving the spectral response range and overall light absorption capacity.

The present embodiment further provides a cell assembly, including a plurality of solar batteries 100.

The plurality of solar batteries 100 in the cell assembly may be connected in series in sequence to form a cell string. The cell strings may be connected in series, in parallel, or in a series-parallel combination to achieve current confluence output. For example, the connection between cell pieces may be achieved by welding a welding strip, and the connection between the cell strings may be achieved by a busbar.

The cell assembly may further include a metal frame, a backsheet, photovoltaic glass, and an adhesive film (not shown in the figures). The adhesive film may be filled between a light-receiving surface of the solar cell 100 and the photovoltaic glass, a backlight surface, the backsheet, the adjacent cell piece, and the like as a filler, the adhesive film may be a transparent adhesive with good light transmittance and aging resistance. For example, the adhesive film may be an EVA adhesive film or a POE adhesive film, which may be selected according to the actual situation, and is not limited herein.

The photovoltaic glass may cover the adhesive film on the light-receiving surface of the solar cell 100, and the photovoltaic glass may be ultra-white glass having high light transmittance, high transparency, and superior physical, mechanical, and optical properties, for example, the light transmittance of the ultra-white glass may reach 92% or more, which can protect the solar cell 100 without affecting the efficiency of the solar cell 100 as much as possible. At the same time, the adhesive film may bond the photovoltaic glass and the solar cell 100 together, and the presence of the adhesive film may seal and insulate the solar cell 100 and providing water and moisture resistance.

The backsheet may be attached to the adhesive film on the backlight surface of the solar cell 100, the backsheet may protect and support the solar cell 100, and has reliable insulation, water resistance and aging resistance. The backsheet may have multiple choices, usually tempered glass, organic glass, aluminum alloy TPT composite adhesive film, etc., which may be specifically set according to the specific situation, and is not limited herein. The whole composed of the backsheet, the solar cell 100, the adhesive film, and the photovoltaic glass may be disposed on the metal frame, and the metal frame serves as a main external support structure of the entire cell assembly, and may stably support and mount the cell assembly, for example, the cell assembly may be mounted at a desired mounting position through the metal frame.

The beneficial effects of the cell assembly of the present embodiment are equivalent to the beneficial effects of the above solar cell 100, which will not be elaborated herein.

The present embodiment further provides a photovoltaic system, including the cell assembly.

The photovoltaic system may be applied to photovoltaic power stations, such as ground power stations, rooftop power stations, or water surface power stations, and may also be applied to devices or apparatuses that use solar energy for power generation, such as user solar power sources, solar street lights, solar cars, or solar buildings. Of course, it may be understood that the application scenarios of the photovoltaic system are not limited to this, that is, the photovoltaic system may be applied in all fields where the solar energy is required for power generation. Taking a photovoltaic power generation system network as an example, the photovoltaic system may include a photovoltaic array, a combiner box, and an inverter. The photovoltaic array may be an array combination of a plurality of cell assemblies. For example, the plurality of cell assemblies may form a plurality of photovoltaic arrays, and the photovoltaic arrays are connected to the combiner box. The combiner box may combine current generated by the photovoltaic array, and the combined current flows through the inverter to be converted into alternating current required by a mains power grid and then connected to the mains power network to achieve solar power supply.

The beneficial effects of the photovoltaic system of the present embodiment are equivalent to the beneficial effects of the above cell assembly, which will not be elaborated herein.

The above are merely preferred embodiments of the present disclosure, but are not intended to limit the present disclosure. Any modification, equivalent replacement, improvement, or the like made within the spirit and principle of the present disclosure should fall within the scope of protection of the present disclosure.

## Claims

1. A solar cell, comprising:
a silicon substrate, the silicon substrate having a backlight surface and a light-receiving surface, which are oppositely disposed, the backlight surface comprising a first region and a second region, a distance from the first region to the light-receiving surface being greater than a distance from the second region to the light-receiving surface, the first region and the second region being alternately disposed, the second region extending toward the first region to form a connection region, and the connection region partially overlapping with the first region;
a first polarity functional layer group disposed on the first region in a stacked manner, at a first preset position, along an arrangement direction of the first region and the second region, at least some functional layers in the first polarity functional layer group having an extending portion extending above the connection region;
a second polarity functional layer group disposed on the second region in a stacked manner;
a third polarity functional layer group disposed on the connection region in a stacked manner, the polarity of the third polarity functional layer group being the same as that of the second polarity functional layer group, and the polarity of the third polarity functional layer group being different from that of the first polarity functional layer group;
at the first preset position, the first polarity functional layer group is in composite contact with the third polarity functional layer group, at least some functional layers in the third polarity functional layer group have a wrapping portion, and the wrapping portion covers the extending portion in a stacked manner and extends to cover the first polarity functional layer group;and
an edge of the wrapping portion closest to the connection region is a first boundary line, an edge of the wrapping portion farthest away from the connection region is a second boundary line, and the degree of undulation of the first boundary line is greater than that of the second boundary line.

2. The solar cell according to claim 1, wherein the adjacent first region and the second region are separated by a groove region, a portion of the second region is connected to the first region through the connection region, an edge of the first polarity functional layer group closest to the groove region is a third boundary line, and the degree of undulation of the third boundary line is greater than that of the first boundary line.

3. The solar cell according to claim 2, wherein the first polarity functional layer group comprises a first dielectric layer and a first polarity doped layer, the second polarity functional layer group comprises a second dielectric layer and a second polarity doped layer, and the third polarity functional layer group comprises a third dielectric layer, a fourth dielectric layer, and a third polarity doped layer;
the first dielectric layer is disposed on the first region in a stacked manner, the first polarity doped layer is disposed on the first dielectric layer in a stacked manner, at the first preset position, along an arrangement direction of the connection region and the first region, the first polarity doped layer has a first extending portion extending above the connection region, and the first extending portion has a first surface facing the connection region and a second surface facing away from the connection region;
the second dielectric layer is disposed on the second region in a stacked manner, and the second polarity doped layer is disposed on the second dielectric layer in a stacked manner;
the third dielectric layer is disposed on the connection region in a stacked manner, the fourth dielectric layer is disposed on at least a portion of the first surface, the fourth dielectric layer has a tunneling function, the third polarity doped layer is disposed on the third dielectric layer and the fourth dielectric layer in a stacked manner, the third polarity doped layer on the third dielectric layer is connected to the third polarity doped layer on the fourth dielectric layer, the third polarity doped layer has a first wrapping portion at the first preset position, and the first wrapping portion wraps around an end of the first extending portion and the second surface of the first extending portion and extends to the first region.

4. The solar cell according to claim 3, wherein an insulating layer is disposed between the first wrapping portion and the second surface.

5. The solar cell according to claim 4, wherein the insulating layer has a second extending portion protruding from the first extending portion along the arrangement direction of the connection region and the first region.

6. The solar cell according to claim 3, wherein the first surface and the second surface intersect at the end of the first extending portion to form a tip portion, and the first wrapping portion wraps around the tip portion.

7. The solar cell according to claim 6, wherein an end of the tip portion has a hole.

8. The solar cell according to claim 3, wherein, at a second preset position of the groove region, along the arrangement direction of the first region and the second region, the first polarity doped layer has a third extending portion extending above the groove region.

9. A cell assembly, comprising a plurality of solar batteries according to claims 1 to 8.

10. A photovoltaic system, comprising the cell assembly according to claim 9.
